# EUROPEAN PATENT APPLICATION

(11) **EP 3 846 229 A1**
(43) Date of publication of application: **07.07.2021**
(21) Application number: 19854119.5
(22) Date of filing: 17.04.2019
(51) Int. Cl.: H01L 33/48

(54) **LIGHT-EMITTING MEANS AND MANUFACTURING METHOD THEREFOR, LEAD FRAME, SUPPORT AND LIGHT-EMITTING DEVICE**

(30) Priority: 30.08.2018 CN 201811006329
(71) Applicant: Shenzhen Jufei Optoelectronics Co., Ltd., Guangdong 518111 (CN)
(72) Inventor: SUN, Pingru, Shenzhen, Guangdong 518111 (CN); SHEN, Binbin, Shenzhen, Guangdong 518111 (CN); LI, Zhuangzhi, Shenzhen, Guangdong 518111 (CN); YAO, Yalan, Shenzhen, Guangdong 518111 (CN); XING, Meizheng, Shenzhen, Guangdong 518111 (CN)
(74) Representative: Himmelsbach, Mathias
(86) International application number: PCT/CN2019/083114
(87) International publication number: WO 2020/042632

(57) **Abstract**

Disclosed are a light-emitting means and a manufacturing method therefor, a lead frame (10), a support and a light-emitting device. A support forming region (11) in the lead frame (10) is internally provided with a supporting portion (12) and a lead portion (13) which extend from the main body of the lead frame (10), the supporting portion (12) comprises first and second supporting portions (121/122) arranged opposite to each other, the support forming region (11) is configured for forming a base body (20), and the supporting portion (12) is configured for being respectively embedded into a first outer side face (21) and a second outer side face (22) that are arranged opposite to each other on the formed base body (20). The supporting portions (12) on the lead frame (10) extend respectively into bayonets (23) provided merely on opposite side surfaces of an LED product, so as to fix six degrees of freedom of the LED product, improving the stability of the LED product when same is fixed.

## Description

### Background of the Invention

### 1. Field of the Invention

The present invention relates to the technical field of LED (Light-emitting Diode), in particular to a light-emitting means and a manufacturing method therefor, a lead frame, a support and a light-emitting device.

### 2. Description of the Prior Art

In recent years, LEDs have played an important role in the display field of mobile appliances due to their unique advantages such as low price, low power consumption, high brightness and long life, and possess great development potential for a long time in the future. In the existing LED manufacturing process, the steps of forming an LED support and packaging an LED light-emitting means are performed on a lead frame. The lead frame provides a lead for the LED product and supports the forming and packaging process. The conventional lead frame supports the LED product by forming two supporting portions opposite to each other in bayonets on two sides of the LED product. The bayonets open to one side surface and another side surface adjacent to both sides, which enables the supporting portion to exit from an opening on another side surface adjacent to both sides of the LED light-emitting means so as to unload of the LED light-emitting means. In this case, the supporting portion of the lead frame can only fix the five degrees of freedom of the LED product. The limited fixing function of the LED product on the lead frame may cause the LED product to fall off the lead frame during the manufacturing process.

### Summary of the Invention

### Technical problem

The light-emitting means and the manufacturing method therefor, the lead frame, the support, and the light-emitting device provided by the present invention mainly solve the following technical problem: the supporting portion on the existing lead frame can only fix five degrees of freedom of the LED product, and as a result, the limited fixing performance of the LED product on the lead frame may cause the LED product being easy to fall off from the lead frame during the manufacturing process.

### Technical solutions

In order to solve the above technical problem, an embodiment of the present invention provides a lead frame, which includes at least one hollowed-out support forming region. The support forming region has a supporting portion and a lead portion that are extending from a main body of the lead frame. The supporting portion includes a first supporting portion and a second supporting portion arranged opposite to each other. The support forming region is configured for forming a base body through an unsaturated polyester resin. The supporting portions are configured for embedding respectively into a first outer side surface and a second outer side surface arranged on opposite sides of the formed base body. When the base body receives an external force acting on the main body of the lead frame, the supporting portion is detached from inside of the base body to form a bayonet on the base body. The bayonet includes a first bayonet and a second bayonet opening from inside of the base body to the first outer side surface and the second outer side surface, respectively.

Preferably, a surface of the lead portion is covered with a reflective layer.

Preferably, the lead portion and the supporting portion are located on the same plane. Preferably, the lead portion and the supporting portion have the same thickness. Preferably, the lead portion is arranged separately from the supporting portion, and one end of the supporting portion is an open end.

Preferably, an end surface of the open end is provided with a protrusion, or a surface of the supporting portion close to the open end is provided in a wedge shape.

In order to solve the above technical problem, an embodiment of the present invention further provides an LED support, which includes the lead portion of the lead frame described above and the base body formed in the support forming region of the lead frame through the unsaturated polyester resin. The base body is provided with a groove for encapsulating an LED chip. The base body is provided with bayonets that open respectively from inside of the base body to a first outer side surface and a second outer side surface arranged on opposite sides of the base body. The supporting portion extended from the main body of the lead frame is applied with a force acting on the main body of the lead frame and is detached from inside of the base body to form a bayonet.

Preferably, a filler and/or titanium oxide is added to the unsaturated polyester resin, and the filler includes a glass fiber and silica.

Preferably, the unsaturated polyester resin added with the filler and/or titanium oxide is further added with a preset additive. A composition ratio of the unsaturated polyester resin, glass fiber, silica, titanium oxide, and the preset additive are A, B, C, D and E, respectively, wherein 15% < A < 25%, 5% < B < 20%, 20% < C < 30%, 30% < D < 40%, 1% < E < 3%, A+B+C+D+E=100%.

In order to solve the above technical problem, an embodiment of the present invention further provides an LED light-emitting means, which includes the above-mentioned LED support and at least one LED chip encapsulated in a base body of the LED support.

In order to solve the above technical problems, an embodiment of the present invention further provides a light-emitting device, which includes the above-mentioned light-emitting means. The light-emitting device is a lighting device, a light signal indicating device, a light supplement device or a backlight device.

To solve the above technical problems, an embodiment of the present invention further provides a method for manufacturing an LED light-emitting means, including: preparing a lead frame, wherein the prepared lead frame includes at least one hollowed-out support forming region having a supporting portion and a lead portion extending from a main body of the lead frame, the supporting portion including a first supporting portion and a second supporting portion arranged opposite to each other; forming a base body in the support forming region through an unsaturated polyester resin, wherein the base body has a groove for encapsulating an LED chip, and the supporting portions embedded respectively into a first outer side surface and a second outer side surface arranged on opposite sides of the formed base body; applying a force acting on the main body of the lead frame after the LED chip is encapsulated so as to detach the supporting portion from inside of the base body to form a bayonet on the base body after detachment, wherein the bayonet includes a first bayonet and a second bayonet that open from inside of the base body to the first outer side surface and the second outer side surface, respectively.

Preferably, after forming the base body in the support forming region through the unsaturated polyester resin, the method further includes:
separating the lead portion from the main body of the lead frame.

Preferably, after separating the lead portion from the main body of the lead frame, the method further includes:
bending a part of the lead portion that protrudes outwardly along a vertical direction of a third outer surface of the base body to attach to a surface of the base body.

Preferably, the lead portion and the bayonet are located on the same plane.

Preferably, a thickness of the lead portion is equal to a width of the bayonet.

Preferably, forming the base body in the support forming region through the unsaturated polyester resin includes:
forming the base body in the support forming region through the unsaturated polyester resin added with a filler and/or titanium oxide, wherein the filler includes a glass fiber and silica.

Preferably, when forming the base body in the support forming region through the unsaturated polyester resin added with the filler and/or titanium oxide, the unsaturated polyester resin is further added with a preset additive.

A composition ratio of the unsaturated polyester resin, glass fiber, silica, titanium oxide, and the preset additive are A, B, C, D and E, respectively, wherein 15% < A < 25%, 5% < B < 20%, 20% < C < 30%, 30% < D < 40%, 1% < E < 3%, A+B+C+D+E=100%.

### Beneficial effect

According to the embodiment of the present invention, a light-emitting means and a manufacturing method therefor, a lead frame, a support, and a light-emitting device are provided. The lead frame includes at least one hollowed-out support forming region having a supporting portion and a lead portion that are extending from a main body of the lead frame. The supporting portion includes a first supporting portion and a second supporting portion arranged opposite to each other. The support forming region is configured for forming a base body through an unsaturated polyester resin. The supporting portions are configured for embedding respectively into a first outer side surface and a second outer side surface arranged on opposite sides of the formed base body. When the base body receives an external force acting on the main body of the lead frame, the supporting portion is detached from inside of the base body to form a bayonet on the base body. The bayonet includes a first bayonet and a second bayonet opening from inside of the base body to the first outer side surface and the second outer side surface, respectively. The supporting portions of the lead frame according to the embodiment of the present invention extend respectively into the bayonets opening on the opposite side surfaces of the LED support to fix the LED support in six degrees of freedom, thereby providing high stability when fixing the LED support and effectively preventing the LED support from falling off the lead frame during the manufacturing process, and thus improving the yield of the LED support. Further, the unload of the LED light-emitting means of the present embodiment is performed by applying a force in a direction perpendicular to the lead frame, so that the LED light-emitting means is loaded and unloaded in a vertical direction. This enables a simultaneous unload operation of multiple LED light-emitting means on the lead frame, thereby improving the production efficiency of the LED light-emitting means, and effectively reducing the production cost.

### Brief Description of the Drawings

FIG. 1 is a schematic diagram of a formed LED support according to Embodiment 1 of the present invention.
FIG. 2 is a schematic structural diagram of a lead frame according to Embodiment 1 of the present invention.
FIG. 3 is a schematic side view of an LED support according to Embodiment 1 of the present invention.
FIG. 4 is a schematic structural diagram of a supporting portion according to Embodiment 1 of the present invention.
FIG. 5 is a schematic structural diagram of an LED light-emitting means according to Embodiment 1 of the present invention.
FIG. 6 is a flowchart of a method for manufacturing an LED light-emitting means according to Embodiment 2 of the present invention.
FIG. 7a is a schematic diagram showing the lead portion before punching and separating according to Embodiment 2 of the present invention.
FIG. 7b is a schematic diagram showing the lead portion after punching and separating according to Embodiment 2 of the present invention.
FIG. 8a is a schematic diagram of a lead portion that protrudes outwardly along a vertical direction of a side surface of a base body according to Embodiment 2 of the present invention.
FIG. 8b is a schematic diagram of a lead portion being bent and attached to a surface of a base body according to Embodiment 2 of the present invention.
FIG. 9a is a schematic diagram of an LED light-emitting means fixed on a supporting portion according to Embodiment 2 of the present invention.
FIG. 9b is a schematic diagram showing the LED light-emitting means being removed by a force according to Embodiment 2 of the present invention.

### Detailed Description of Embodiments

In order to make the objectives, technical solutions and advantages of the embodiments of the present invention clearer, the following further describes the embodiments of the present invention in detail through specific implementations and the accompanying drawings. It should be understood that the specific embodiments described herein are only used for illustrating the embodiments of the present invention, but not for limiting the scope of the present invention.

### Embodiment 1:

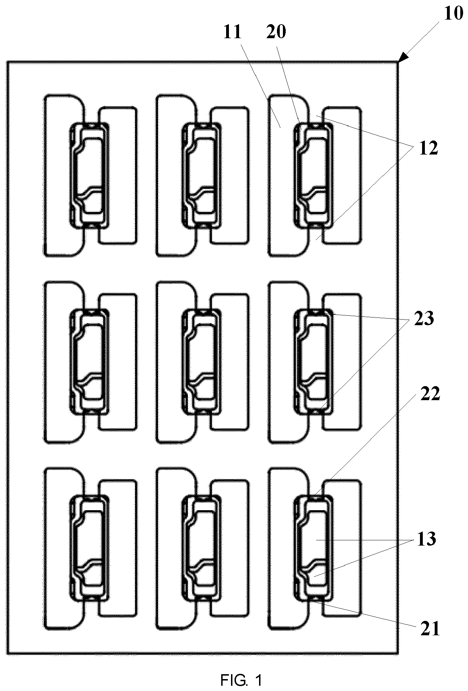

In the conventional art, the LED light-emitting means is unloaded by separating the supporting portion of the lead frame from the bayonets that are opened on the opposite side surfaces of the LED light-emitting means, which causes the LED light-emitting means easily damaged by the force during an unload process. An embodiment of the present invention provides a lead frame 10, as shown in FIG. 1, the lead frame 10 includes at least one hollowed-out support forming region 11 having a supporting portion 12 and a lead portion 13 that are extending from a main body of the lead frame 10. The supporting portion 12 includes a first supporting portion and a second supporting portion arranged opposite to each other. The support forming region 11 is configured for forming a base body 20 through an unsaturated polyester resin. The supporting portions 12 are configured for embedding into a first outer side surface 21 and a second outer side surface 22 that are arranged on opposite sides of the formed base body 20, respectively. When the base body 20 receives an external force acting on the main body of the lead frame 10, the supporting portion 12 is detached from inside of the base body 20 to form a bayonet 23 on the base body 20. The bayonet 23 includes a first bayonet and a second bayonet opening from inside of the base body 20 to the first outer side surface 21 and the second outer side surface 22, respectively.

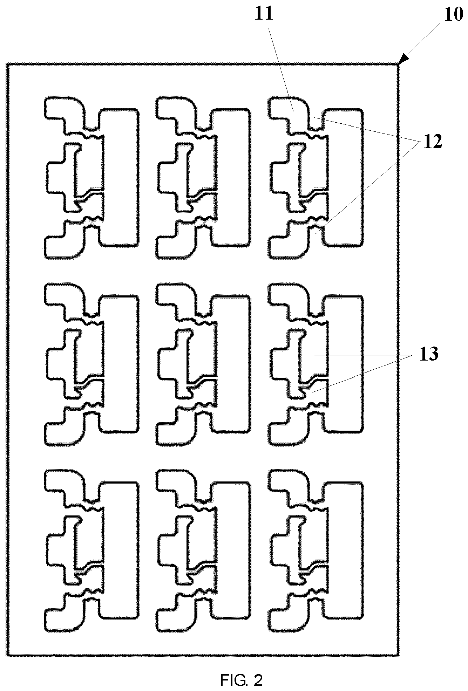

Referring to FIG. 2, in the present embodiment, the lead frame 10 may be formed by performing a punching process or an etching process on a conductive plate, thereby forming at least one hollowed-out support forming region 11 on the lead frame 10. After removing the material of the hollowed-out region from the lead frame 10, the remaining portion forms the lead portion 13 and the supporting portion 12, and the supporting portion 12 and the lead portion 13 extend from the main body of the lead frame 10 to the hollowed-out region, respectively. In other embodiments, the supporting portion and the lead portion may also extend from the main body of the lead frame to the hollowed-out region as a whole, that is, the lead portion connects to the main body of the lead frame through the supporting portion. The lead portion 13 is provided with a die-bonding region for mounting an LED chip and is configured to conduct the LED chip mounted thereon thereafter. The supporting portion 12 is configured to provide internal support for an LED product during molding the LED support on the lead frame 10 and packaging the LED light-emitting means. The supporting portions 12 in the present embodiment are oppositely arranged. It should be noted that the first supporting portion and the second supporting portion may be a single supporting portion or may be presented by combining a plurality of single supporting portions, respectively.

It should be understood that the lead frame in the present embodiment may be a substrate made of various conductive materials, such as a metal substrate or a metal alloy substrate, including but is not limited to, copper substrate, aluminum substrate, iron substrate, or silver substrate. It may also be a mixed material substrate including a conductive material, such as a conductive rubber. In the present embodiment, the lead frame is preferably made by copper alloy so as to ensure good conductivity and heat dissipation. Furthermore, the lead frame according to the present embodiment may be a thin plate that facilitates a subsequent bending process and can be easily formed into a predetermined shape. Moreover, the lead frame is not limited to a single-layer structure, and in some embodiments, the lead frame may be a composite layer structure including multiple layers of conductive materials.

In addition, according to the present embodiment, in order to improve the reflectivity of the light emitted by the LED chip, a surface of the lead portion may be coated with a reflective layer, wherein the reflective layer may be, such as silver, aluminum, copper, or gold. The reflective layer may preferably be coated by electroplating. It should be noted that the coating process of the reflective layer herein may be performed on the entire lead frame before the LED support is formed, or alternatively, the coating process may also be performed only on the lead portion where the die-bonding region for mounting the LED chip is located after the LED support is formed. In order to further enhance the reflectivity of the surface of the lead portion, it is preferable that the lead portion may have a smooth surface.

Referring to FIG. 2 again, it should be noted that, as a preferred implementation, the lead portion 13 in the present embodiment extends from the main body of the lead frame 10 to the hollowed-out region and is formed in the space between the supporting portions 12. The positive lead portion and the negative lead portion of the lead portion 13 are separated to form an insulating isolation region. Each of the opposite supporting portions 12 has an open end, and the open end is arranged separately from the lead portion 13. The open end herein refers to an end that does not connect to other components. Alternatively, in other embodiments, the supporting portion may not be provided with an open end, that is, the supporting portion extends from the main body of the lead frame to the lead portion and connects to the lead portion. In this case, it is necessary to ensure that the lead portion will eventually be separated from the supporting portion in actual production.

Preferably, the lead portion 13 and the supporting portion 12 in the present embodiment are located on the same plane, and further, the lead portion 13 and the supporting portion 12 have the same thickness, so that the manufacturing process can be implemented more easily and with higher controllability.

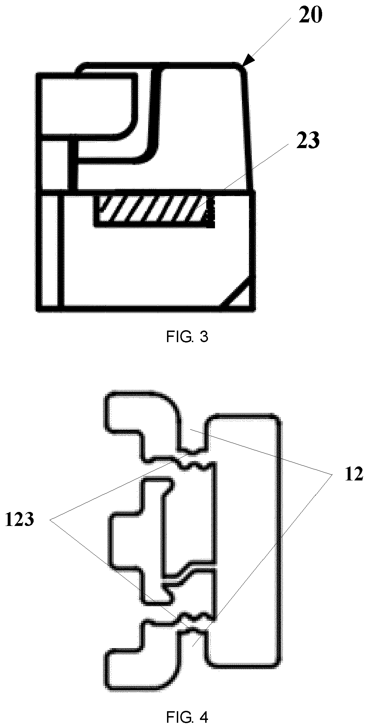

According to the present embodiment, in order to ensure that the supporting portion is separated from the LED light-emitting means during the unload process, a bayonet corresponding to the supporting portion is formed on the base body of the LED support. A single bayonet only opens on one side surface of the base body for the supporting portion to be detached from the bayonet. Referring to FIG. 1 again and FIG. 3, the LED support in the present embodiment includes the lead portion 13 of the above-mentioned lead frame 10 and the base body 20 formed in the support forming region 11 of the lead frame 10 through an unsaturated polyester resin. The base body 20 is provided with a groove for encapsulating the LED chip. The base body 20 is provided with bayonets 23 that open respectively from inside of the base body 20 to a first outer side surface 21 and a second outer side surface 22 arranged on opposite sides of the base body 20. The bayonet 23 includes a first bayonet and a second bayonet. When the base body 20 receives an external force acting on the main body of the lead frame 10, the supporting portion 12 extended from the main body of the lead frame 10 in the support forming region 11 is detached from inside of the base body 20 to form a bayonet 23.

In the present embodiment, the LED support is formed in the support forming region of the lead frame through clamping by the lead frame in the mold and injection molded. The base body of the formed LED support is provided with a groove as an encapsulating region for the LED chip, wherein at least a partial of the lead portion of the lead frame is exposed from a bottom surface of the groove, thereby serving as a die-bonding region for mounting the LED chip. In actual application, the LED chip can be mounted on a positive lead portion and electrically connected to the positive lead portion through a metal wire, and then the LED chip is connected to a negative lead portion through another metal wire. Alternatively, if the LED chip is a flip chip, then the metal wire for connecting the LED chip to the lead portion can be eliminated. The groove has an opening toward the top of the base body, so that the inside of the groove can be encapsulated with a sealing material through the opening.

Specifically, referring to FIG. 3 again, a bayonet 23 that opens to the side surface of the base body 20 is formed. A single bayonet 23 opens merely on one side surface, for example, two bayonet 23 open on the first outer side surface 21 and the second outer side surface 22, respectively. When the supporting portion is located within the bayonet and the supporting portion is not deformed, the six degrees of freedom, namely, the front, rear, left, right, upper, and lower sides of the base body, can be fixed by the supporting portion, and thus renders high stability.

According to the present embodiment, each of the two bayonets on the opposite side surfaces of the base body has an opening only on one side surface, and therefore, if the supporting portion is to be removed and detached from the bayonet opening, the supporting portion needs to deform to be detached. In the present embodiment as shown in FIG. 4, in order to facilitate a smooth removal of the deformed supporting portion from the bayonet opening through applying a force, a protrusion 123 is arranged in an end surface of an open end of the supporting portion 12. When the open end of the supporting portion 12 approaches the bayonet opening, the open end is in point contact with the bayonet opening through the protrusion 123 and is more likely to be detached under a force in comparison to the conventional line contact between the open end and the bayonet opening. Moreover, in other embodiments, it is also possible to set a surface near the open end of the supporting portion in a wedge shape, which also facilitates the detachment of contact with the bayonet opening.

According to the present embodiment, an unsaturated polyester resin is used to form the base body in the support forming region. As a thermosetting resin, the unsaturated polyester resin has excellent reflectivity and resistance to deterioration such as ultraviolet rays, and therefore may effectively suppress the deterioration of a reflector or a resin and maintain high reflectivity and light efficiency of the LED light-emitting means under long-time light emission. In addition, the unsaturated polyester resin does not possess a reactive functional group such as a hydroxyl group (-OH group) and does not form a chemical bond with a metal. Therefore, it is less likely to produce a resin burr during the molding process. Even if the resin burr occurs, it can be easily peeled off. Moreover, the melting point of unsaturated polyester resin is around 50°C-90°C, which can prevent the carbonization of an organic substance added in the resin during injection molding of the unsaturated polyester, thereby effectively suppressing molding defects. In addition, the unsaturated polyester resin has a higher fluidity than a thermoplastic resin, and therefore can be injected with a lower injection pressure to reduce the possibility of lead frame deformation. During the injection molding process, there is no need to hold the lead frame, and the mold can be simplified.

In actual application, the unsaturated polyester resin may be further added with a filler composed of longer fibers, such as glass fiber and spherical silica, to increase the strength of the resin. Further, titanium oxide may also be added to the unsaturated polyester to increase the light reflectivity of the resin.

Moreover, the following substance may be added to the filler or titanium oxide or both in an appropriate combination: maleic anhydride, fumaric acid, styrene, filler, reinforcing agent, curing agent, mold release agent, pigment, or other additives.

In a preferred embodiment, when the filler, titanium oxide and the additive are added to the unsaturated polyester resin, and a composition ratio of the unsaturated polyester resin, glass fiber, silica, titanium oxide and additive are A, B, C, D and E, respectively, wherein 15% < A < 25%, 5% < B < 20%, 20% < C < 30%, 30% < D < 40%, 1%<E<3%, A+B+C+D+E=100%. By applying the composition ratio of the present embodiment, the cracking and discoloration of the unsaturated polyester resin can be effectively inhibited.

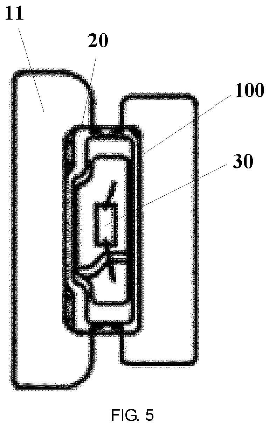

As shown in FIG. 5, the present embodiment also provides an LED light-emitting means 100 made by utilizing the above-mentioned LED support, wherein the LED light-emitting means 100 includes the LED support and at least one LED chip 30 encapsulated within the base body 20 of the LED support.

The color of the light emitted and presented to a user by the LED light-emitting means of the present embodiment may be flexibly adjusted according to actual needs and application scenarios. The color of the light emitted by the LED light-emitting means may be flexibly controlled by, but is not limited to, the following factors: the color of the light emitted by the LED chip itself, whether the LED light-emitting means is equipped with a light conversion layer, and if yes, the type of light conversion layer.

In an example of the present embodiment, the LED light-emitting means may further include a lens gel layer or a diffusion gel layer disposed on the LED chip (or disposed on a light conversion gel layer if equipped with a light conversion gel layer). Moreover, in some examples, a transparent gel layer may also be disposed on the LED chip.

It should be understood that, in an example, the light conversion gel layer may be a fluorescent gel layer containing a phosphor, or a colloid containing a quantum dot photoluminescence material, or other light conversion gels or films that can perform light conversion. It may also include diffusion powder or silicon powder as required. According to the present embodiment, the method of forming the light conversion gel layer, the lens gel layer or the diffusion gel layer on the LED chip includes, but is not limited to, dispensing, molding, spray coating, pasting, etc.

For example, the light conversion gel layer may include a phosphor gel layer, a fluorescent film, or a quantum dot QD film. The phosphor gel layer and the fluorescent film may be made of inorganic phosphors, which may be inorganic phosphors doped with rare earth elements. Inorganic phosphors may include, but are not limited to, at least one of silicate, aluminate, phosphate, nitride, or fluoride phosphors.

For another example, the quantum dot QD film can be made of quantum dot phosphors. The quantum dot phosphors may include, but are not limited to, at least one of BaS, AgInS₂, NaCl, Fe₂O₃, In₂O₃, InAs, InN, InP, CdS, CdSe, CdTe, ZnS, ZnSe, ZnTe, GaAs, GaN, GaS, GaSe, InGaAs, MgSe, MgS, MgTe, PbS, PbSe, PbTe, Cd(SₓSe₁₋ₓ), BaTiO₃, PbZrO₃, CsPbCl₃, CsPbBr₃, CsPbl₃.

In the present embodiment, the type of light emitted by the LED chip itself may be visible light that is visible to the naked eyes, ultraviolet light or infrared light that is invisible to the naked eyes. When the type of light emitted by the LED chip itself is ultraviolet light or infrared light that is invisible to the naked eyes, a light conversion layer may be disposed on the LED chip to convert the invisible light to visible light, such that the light emitted by the LED light-emitting means is visible to the user. For example, when the light emitted by the LED chip itself is ultraviolet light, and if the LED light-emitting means is supposed to present white light visible to the user, the light conversion layer may be made by mixing red, green, and blue phosphors.

The two opposite supporting portions on the lead frame provided by the embodiment of the present invention extend respectively into the bayonet openings on two opposite side surfaces of the LED support so as to fix the LED support in six degrees of freedom, thereby providing high stability when fixing the LED support and effectively preventing the LED support from falling off the lead frame during the manufacturing process, and thus improving the yield of the LED support. Further, the unload of the LED light-emitting means in the embodiment of the present invention is to apply a force in a direction perpendicular to the lead frame, so that the LED light-emitting means is loaded and unloaded in a vertical direction. This enables a simultaneous unload operation of multiple LED light-emitting means on the lead frame, thereby improving the production efficiency of the LED light-emitting means, and effectively reducing the production cost.

### Embodiment 2:

In order to facilitate a comprehensive understanding of the embodiments of the present invention, the manufacturing process of the LED light-emitting means provided in the embodiment of the present invention is illustrated below.

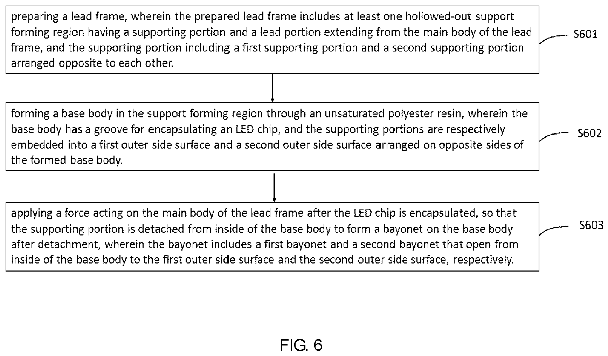

Please referring to FIG. 6, FIG. 6 is a flowchart of a method for manufacturing an LED light-emitting means provided by the present embodiment. The specific implementation steps for manufacturing the LED light-emitting means include:
S601: preparing a lead frame, wherein the prepared lead frame includes at least one hollowed-out support forming region having a supporting portion and a lead portion extending from the main body of the lead frame, and the supporting portion including a first supporting portion and a second supporting portion arranged opposite to each other.

In the present embodiment, the lead frame is formed by stamping or etching the conductive substrate to selectively remove the material in the predetermined region. The formed lead frame includes a support forming region that is configured for injection molding in a mold to form a base body of the LED support. The supporting portions on the lead frame are arranged oppositely, so that the LED support formed thereon can be held firmly. It should be noted that, in a preferred embodiment, the supporting portion and the lead portion respectively extend from the main body of the lead frame to the hollowed-out region. After the lead portion and the supporting portion extend from the main body of the lead frame, an end of the lead portion and an end of the supporting portion that are away from the main body of the lead frame are both open ends that do not connect to other components. Alternatively, in other embodiments, the supporting portion and the lead portion may extend from the main body of the lead frame to the hollowed-out region as a whole, that is, the lead portion connects to the main body of the lead frame through the supporting portion.

S602: forming a base body in the support forming region through an unsaturated polyester resin, wherein the base body has a groove for encapsulating an LED chip, and the supporting portions are respectively embedded into a first outer side surface and a second outer side surface arranged on opposite sides of the formed base body. In this step, the unsaturated polyester resin is used for injection molding to form the base body in the support forming region. In actual application, the unsaturated polyester resin may be further added with a filler and/or titanium oxide. The filler includes a glass fiber and silica. The addition of the filler may increase the strength of the resin, and the addition of titanium oxide may increase the light reflectivity of the resin. Moreover, the following substance may be added to the filler or titanium oxide or both in an appropriate combination: maleic anhydride, fumaric acid, styrene, fillers, reinforcing agent, curing agent, mold release agent, pigment or other additives.

In a preferred embodiment, when the filler, titanium oxide and the additive are added to the unsaturated polyester resin, a composition ratio of the unsaturated polyester resin, glass fiber, silica, titanium oxide and additive are A, B, C, D and E, respectively, wherein 15% < A < 25%, 5% < B < 20%, 20% < C < 30%, 30% < D < 40%, 1% < E < 3%, A+B+C+D+E=100%. By applying the composition ratio of the present embodiment, the cracking and discoloration of the unsaturated polyester resin can be effectively inhibited.

When the injection molding is completed, the mold is heated for a predetermined time to harden the resin. At this time, the supporting portion and the lead portion on the lead frame are embedded in the base body, and the supporting portions are respectively embedded into the base body from two opposite side surfaces of the base body.

In the present embodiment, after the base body is formed in the support forming region through the unsaturated polyester resin, the method further includes separating the lead portion from the main body of the lead frame.

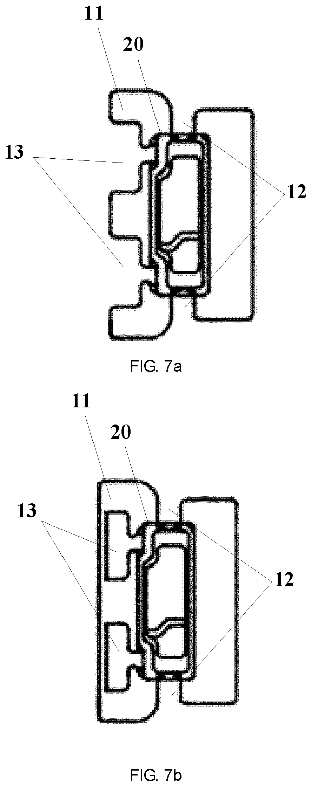

Specifically, in an embodiment where the lead portion 13 and the supporting portion 12 respectively extend from the main body of the lead frame 10 to the hollowed-out region of the support forming region 11, after the lead portion 13 is formed on the base body 20, it is necessary to separate the lead portion 13 from the main body of the lead frame 10, so as to ensure that the LED product can be separated from the lead frame 10 in the later stage, and the lead portion 13 will be kept in the LED product after separation. As shown in Fig. 7a, which is a schematic diagram before punching and separating the lead portion, and as shown in Fig. 7b, which is a schematic diagram after punching and separating the lead portion.

In addition, in the present embodiment, after separating the lead portion from the main body of the lead frame, the method further includes bending a part of the lead portion that protrudes outwardly along a vertical direction of a third outer surface of the base body to attach to a surface of the base body.

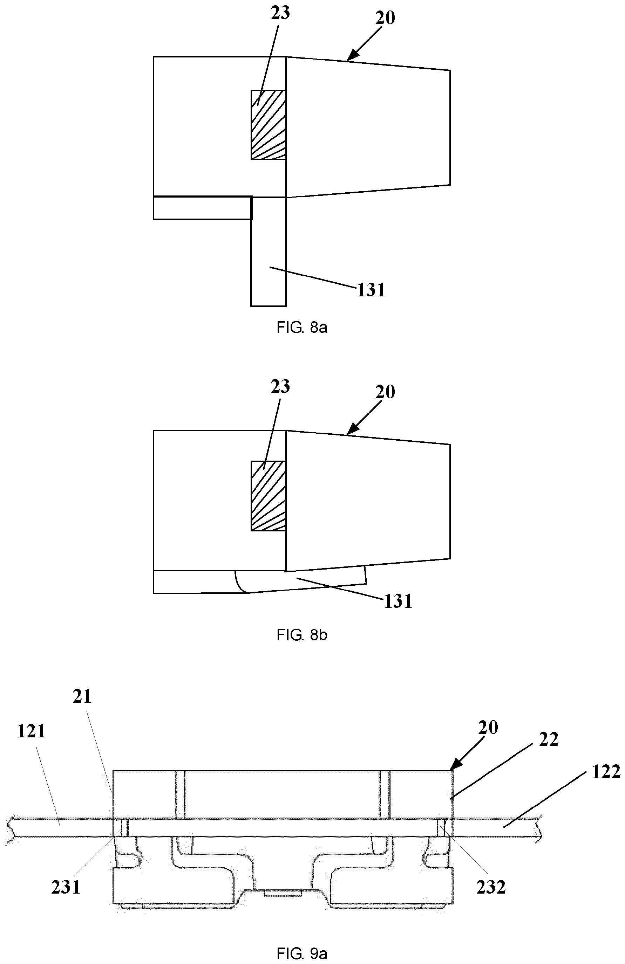

Specifically, in some embodiments as shown in FIG. 8a, after the base body 20 is injection molded on the lead frame, a portion of the lead portion 13 locating inside the base body 20 forms an inner lead portion 13 of a functional area of the LED chip (not shown in Figure 8a), while another portion of the lead portion 13 protruding vertically from a side surface of the base body 20 forms an external lead portion 131. The external lead portion 131 is configured for external electrical connection, such as for soldering on a PCB board. Therefore, in order to facilitate an external electrical connection, as shown in FIG. 8b in the present embodiment, the external lead portion 131 separated from the main body of the lead frame 10 is attached to the surface of the base body 20 by applying a force.

S603: applying a force acting on the main body of the lead frame after the LED chip is encapsulated, so that the supporting portion is detached from inside of the base body to form a bayonet on the base body after detachment, wherein the bayonet includes a first bayonet and a second bayonet that open from inside of the base body to the first outer side surface and the second outer side surface, respectively.

Preferably, the lead portion and the bayonet of the present embodiment are located on the same plane, and further, a thickness of the lead portion is equal to a width of the bayonet, so that the manufacturing process can be implemented more easily and with higher controllability.

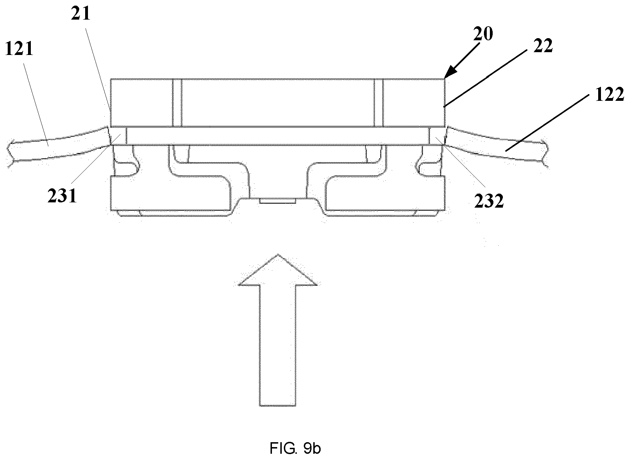

Fig. 9a shows a schematic diagram of the LED light-emitting means fixed on the supporting portion, and Fig. 9b shows a schematic diagram of the LED light-emitting means removed by a force. When removing the LED light-emitting means in the present embodiment, since each bayonet only opens on one side surface of the base body 20, if the base body 20 is to be detached from the supporting portion 12, the supporting portion 12 has to be removed from the bayonet opening on the side surface. This can only be done through bending and deforming the supporting portion 12 by applying a force perpendicular to the plane of the main body of the lead frame, such that the supporting portion 12 is gradually removed from its initial position in the bayonet 23. As shown in FIG. 9a, a first supporting portion 121 and a second supporting portion 122 are respectively embedded into a first bayonet 231 and a second bayonet 232 that are opened on a first outer side surface 21 and a second outer side surface 22, respectively. As shown in 9b, a force acting upward may be applied on a bottom surface of the base body 20, that is, a longitudinal force is applied, so that the supporting portion 12 is bent upward and removed from the bayonet opening. Alternatively, in the present embodiment, it is also possible to apply a force acting downward on the top surface of the base body to bend the supporting portion.

It should be noted that in the present embodiment, the position of the bayonet on the base body may be flexibly adjusted according to actual needs and application scenarios, and it only needs to make sure that each bayonet opens only on one side surface.

According to the method for manufacturing the LED light-emitting means provided by the embodiment of the present invention, the base body is formed in the support forming region of the lead frame by resin, and two oppositely arranged supporting portions on the lead frame extend respectively into the bayonet openings on two opposite side surfaces of the LED light-emitting means. During the unload operation, a force perpendicular to the plane of the lead frame is applied to the LED light-emitting means to bend and deform the supporting portion and to detach the supporting portion from the LED light-emitting means, thereby forming a bayonet at the corresponding position of the LED light-emitting means. The embodiment of the present invention can fix the LED product in six degrees of freedom, thereby providing high stability when fixing the LED product and effectively preventing the LED product from falling off the lead frame during the manufacturing process, and thus improving the yield of the LED means. Further, the unload of the LED light-emitting means in the embodiment of the present invention is to apply a force in a direction perpendicular to the lead frame, so that the LED light-emitting means is loaded and unloaded in a vertical direction. This enables a simultaneous unload operation of multiple LED light-emitting means on the lead frame, thereby improving the production efficiency of the LED light-emitting means, and effectively reducing the production cost.

### Embodiment 3

The present embodiment provides a light-emitting device, which includes the LED light-emitting means exemplified in Embodiment 1 or Embodiment 2. The light-emitting device in the present embodiment may be a lighting device, a light signal indicating device, a light supplement device or a backlight device, etc. In particular as a lighting device, it may be a lighting device used in various fields, such as table lamps, fluorescent lamps, ceiling lamps, downlights, street lamps, projection lamps in daily life; high beams, low beams, ambient lights in automobiles; surgical lamps, low-electromagnetic lighting lamps in the medical field or the lights for various medical instruments; various color lamps, landscape lighting lamps, advertising lamps in the decorative field. In particular as a light signal indicating device, it may be a signal indicator lamp in the traffic field or a signal status indicator of a communication device in the communication field. As a supplementary light device, it may be a supplementary light in the photography field, such as a flash, a supplementary light, or a plant supplementary light that supplements light for plants in the agricultural field. As a backlight device, it may be a backlight module applied to various backlight fields, such as displays, televisions, mobile terminals such as mobile phones, advertising players, etc.

It should be understood that the above-mentioned applications are merely a few applications exemplified for the present embodiment, and the application of the LED light-emitting means is not limited to the above-mentioned examples.

The above detailed description of the embodiments of the present invention in combination with specific implementations is intended merely for elaboration, and the embodiments of the present invention are not limited thereto. For people having ordinary skill in the art, simple deductions or substitutions that can be made without departing from the concept of the embodiments of the present invention should be regarded as falling within the protection scope of the present invention.

## Claims

1. A lead frame, comprising:
at least one hollowed-out support forming region having a supporting portion and a lead portion that are extending from a main body of the lead frame, wherein the supporting portion includes a first supporting portion and a second supporting portion arranged opposite to each other, and the support forming region is configured for forming a base body through an unsaturated polyester resin, the supporting portions are configured for embedding respectively into a first outer side surface and a second outer side surface arranged on opposite sides of the formed base body;
the supporting portion being detached from inside of the base body to form a bayonet on the base body when the base body receives an external force acting on the main body of the lead frame, wherein the bayonet includes a first bayonet and a second bayonet opening from inside of the base body to the first outer side surface and the second outer side surface, respectively.

2. The lead frame of claim 1, wherein a surface of the lead portion is covered with a reflective layer.

3. The lead frame of claim 1, wherein the lead portion and the supporting portion are located on the same plane.

4. The lead frame of claim 1, wherein the lead portion and the supporting portion have the same thickness.

5. The lead frame according to any one of claims 1 to 4, wherein the lead portion is arranged separately from the supporting portion, and one end of the supporting portion is an open end.

6. The lead frame according to claim 5, wherein an end surface of the open end is provided with a protrusion, or a surface of the supporting portion close to the open end is provided in a wedge shape.

7. An LED support comprising a lead portion of a lead frame and a base body formed in a support forming region of the lead frame through an unsaturated polyester resin according to any one of claims 1 to 6, wherein the base body is provided with a groove for encapsulating an LED chip, the base body provided with bayonets that open from inside of the base body to a first outer side surface and a second outer side surface arranged opposite to each other on the base body, respectively, the bayonets including a first bayonet and a second bayonet, wherein the supporting portion extended from the main body of the lead frame is applied with a force acting on the main body of the lead frame and is detached from inside of the base body to form a bayonet.

8. The LED support according to claim 7, wherein the unsaturated polyester resin is added with a filler and/or titanium oxide, and the filler includes a glass fiber and silica.

9. The LED support according to claim 8, wherein the unsaturated polyester resin added with the filler and/or titanium oxide is further added with a preset additive, and a composition ratio of the unsaturated polyester resin, glass fiber, silica, titanium oxide, and the preset additive are A, B, C, D and E, respectively, wherein 15% < A < 25%, 5% < B < 20%, 20% < C < 30%, 30% < D < 40%, 1% < E < 3%, A+B+C+D+E=100%.

10. An LED light-emitting means comprising an LED support according to any one of claims 7 to 9 and at least one LED chip encapsulated in a base body of the LED support.

11. A light-emitting device comprising an LED light-emitting means according to claim 10, wherein the light-emitting device is a lighting device, a light signal indicating device, a light supplement device or a backlight device.

12. A method for manufacturing an LED light-emitting means, comprising:
preparing a lead frame, wherein the prepared lead frame includes at least one hollowed-out support forming region having a supporting portion and a lead portion extending from a main body of the lead frame, the supporting portion including a first supporting portion and a second supporting portion arranged opposite to each other; forming a base body in the support forming region through an unsaturated polyester resin, wherein the base body has a groove for encapsulating an LED chip, the supporting portions embedded respectively into a first outer side surface and a second outer side surface arranged on opposite sides of the formed base body;
applying a force acting on the main body of the lead frame after the LED chip is encapsulated so as to detach the supporting portion from inside of the base body to form a bayonet on the base body after detachment, wherein the bayonet includes a first bayonet and a second bayonet that open from inside of the base body to the first outer side surface and the second outer side surface, respectively.

13. The method for manufacturing an LED light-emitting means according to claim 12, wherein after forming the base body in the support forming region through the unsaturated polyester resin, the method further comprising:
separating the lead portion from the main body of the lead frame.

14. The method for manufacturing an LED light-emitting means according to claim 13, wherein after separating the lead portion from the main body of the lead frame, the method further comprising:
bending a part of the lead portion that protrudes outwardly along a vertical direction of a third outer surface of the base body to attach to a surface of the base body.

15. The method for manufacturing an LED light-emitting means according to claim 12, wherein the lead portion and the bayonet are located on the same plane.

16. The method for manufacturing an LED light-emitting means according to claim 12, wherein a thickness of the lead portion is equal to a width of the bayonet.

17. The method for manufacturing an LED light-emitting means according to any one of claims 12 to 16, wherein forming the base body in the support forming region through the unsaturated polyester resin comprises:
forming the base body in the support forming region through the unsaturated polyester resin added with a filler and/or titanium oxide, wherein the filler includes a glass fiber and silica.

18. The method for manufacturing an LED light-emitting means according to claim 17, wherein when forming the base body in the support forming region through the unsaturated polyester resin added with the filler and/or titanium oxide, the unsaturated polyester resin is further added with a preset additive, and a composition ratio of the unsaturated polyester resin, glass fiber, silica, titanium oxide, and preset additive are A, B, C, D and E, respectively, wherein 15% < A < 25%, 5% < B < 20%, 20% < C < 30%, 30% < D < 40%, 1% < E < 3%, A+B+C+D+E=100%.
